# EUROPÄISCHE PATENTSCHRIFT

(11) **EP 2 755 248 B1**
(45) Veröffentlichungstag und Bekanntmachung des Hinweises auf die Patenterteilung: **10.04.2019**
(21) Anmeldenummer: 13192314.6
(22) Anmeldetag: 11.11.2013
(51) Int. Cl.: H01L 41/083, H01L 41/273, H01L 41/29, H01L 41/338, H01L 41/047, H01L 41/293, H01L 41/337, H01L 41/09, H01L 41/113

(54) **Piezoelektrisches Bauteil und Verfahren zur Herstellung eines piezoelektrischen Bauteils**
Piezoelectric component and method for producing a piezoelectric component
Composant piézoélectrique et procédé de fabrication d'un composant piézoélectrique

(30) Priorität: 10.01.2013 DE 102013200243
(43) Veröffentlichungstag der Anmeldung: 16.07.2014
(73) Patentinhaber: ROBERT BOSCH GMBH, 70442 Stuttgart (DE)
(72) Erfinder: Melcher, Reinhold, 91052 Erlangen (DE); Benes, Jan, 96047 Bamberg (DE)

(56) Entgegenhaltungen:
- EP-A1- 1 061 591
- WO-A1-01/84642
- DE-A1-102005 046 118
- DE-A1-102009 029 521
- JP-A- 2003 197 992
- JP-A- 2010 245 513

## Beschreibung

### Stand der Technik

Die Erfindung betrifft ein piezoelektrisches Bauteil, insbesondere einen piezoelektrischen Sensor oder einen piezoelektrischen Aktor, sowie ein Verfahren zur Herstellung solch eines piezoelektrischen Bauteils. Speziell betrifft die Erfindung das Gebiet der piezokeramischen Drucksensoren, die zur Druckmessung bei Kraftfahrzeugen zum Einsatz kommen.

Aus der DE 10 2010 00 827 A1 ist ein Kraftstoffinjektor mit einem Drucksensor bekannt. Bei dem bekannten Kraftstoffinjektor ist der Drucksensor einem Steuerraum zugeordnet, dessen Druck die Hübe beziehungsweise Stellungen einer Düsennadel bestimmt. Über den Drucksensor kann der Verlauf des Steuerraumdruckes erfasst werden.

Bei der Ausgestaltung eines piezoelektrischen Drucksensors ist es denkbar, diesen aus einzelnen oder mehreren aktiven Lagen aufzubauen. Wenn das Signal einer einzelnen Lage nicht ausreicht, kann es durch eine Erhöhung der Zahl der aktiven Lagen entsprechend vervielfacht werden. Das piezoelektrische Material kann hierbei in Form von runden Scheiben in den Herstellungsprozess eingehen. Solche runden Scheiben können von stabförmigen Halbzeugen abgeschnitten und in hohen Stückzahlen hergestellt werden. Wenn allerdings ein mehrlagiger Aufbau eines Piezosensors gewünscht ist, dann müssen in diesem Fall mehrere solcher einzelnen Scheiben aufwändig gestapelt und miteinander verbunden werden. Die hierfür erforderlichen Prozessschritte für die Aufbau- und Verbindungstechnik führen zu verschiedenen Nachteilen. Zum einen ist der Herstellungsaufwand hoch, was hohe Kosten bedingt. Ferner kommt es zu Toleranzverlusten und Robustheitseinbußen.

### Offenbarung der Erfindung

Das erfindungsgemäße piezoelektrische Bauteil mit den Merkmalen des Anspruchs 1 und das erfindungsgemäße Verfahren mit den Merkmalen des Anspruchs 3 haben den Vorteil, dass ein verbesserter Aufbau des piezoelektrischen Bauteils und eine verbesserte Herstellbarkeit ermöglicht sind. Insbesondere ist in vorteilhafter Weise ein Aufbau mit zwei keramischen Schichten und einer innen liegenden Elektrodenschicht realisierbar, wobei eine zuverlässige und kostengünstig herstellbare Kontaktierung der zwischen den keramischen Schichten angeordneten innen liegenden Elektrodenschicht möglich ist. Außerdem kann eine kosten- und prozesstechnisch günstige Fertigung in hohen Stückzahlen ermöglicht werden.

Durch die in den Unteransprüchen aufgeführten Maßnahmen sind vorteilhafte Weiterbildungen des im Anspruch 1 angegebenen piezoelektrischen Bauteils und des im Anspruch 3 angegebenen Verfahrens möglich.

Das piezoelektrische Bauteil kann mehrere keramische Schichten aufweisen. Wenn das piezoelektrische Bauteil genau zwei keramische Schichten, nämlich die erste keramische Schicht und die zweite keramische Schicht, und genau eine innen liegende Elektrodenschicht aufweist, dann ergeben sich besondere Vorteile bei der Herstellung. Denn bei dieser Ausgestaltung kann die innen liegende Elektrodenschicht in einfacher Weise durch die Außenmetallisierung, die eine Außenelektrode an der Außenseite des Grundkörpers bildet, kontaktiert werden. Ferner kann die stirnseitige Metallisierung ebenfalls einfach ausgestaltet werden. Der Grundkörper mit der einen innen liegenden Elektrodenschicht kann hierbei in vorteilhafter Weise von dem stangenförmigen Block abgetrennt werden. Eine Trennebene beim Abtrennen liegt hierbei vorzugsweise jeweils in der Mitte zwischen zwei benachbarten innen liegenden Elektrodenschichten des stangenförmigen Blocks.

Auf einer weiteren Stirnseite des Grundkörpers, die von der Stirnseite abgewandt ist, ist eine Metallisierung aufgebracht, die eine weitere stirnseitige Außenelektrode bildet, und dass der Grundkörper eine weitere Abtragung aufweist, die die Außenmetallisierung von der weiteren stirnseitigen Außenelektrode trennt. Hierdurch können an den beiden Stirnseiten des Grundkörpers Außenelektroden ausgestaltet werden. Zusammen mit der innen liegenden Elektrodenschicht können somit die beiden keramischen Schichten zur Funktion des piezoelektrischen Bauteils beitragen. Insbesondere kann hierdurch ein entsprechend großes Messsignal beziehungsweise ein entsprechend großer Hub des piezoelektrischen Bauteils erzielt werden.

Die Abtragung ist als Fase ausgestaltet, die an der Stirnseite des Grundkörpers vorgesehen ist. Entsprechend ist die weitere Abtragung ebenfalls als Fase ausgestaltet, die an der weiteren Stirnseite des Grundkörpers vorgesehen ist. Hierbei kann durch ein geeignetes Anschrägen des Grundkörpers die jeweilige Fase ausgestaltet werden.

Dabei basiert der Grundkörper auf einer zylinderförmigen Ausgestaltung, was den Vorteil bietet, dass die Außenmetallisierung einheitlich auf eine zylindermantelförmige Außenseite des Grundkörpers aufgebracht ist und dass die Fase, die an der Stirnseite des Grundkörpers vorgesehen ist, die Stirnseite des Grundkörpers ringförmig umschließt und die Fase, die an der weiteren Stirnseite des Grundkörpers vorgesehen ist, die weitere Stirnseite des Grundkörpers ringförmig umschließt. Die vorzugsweise mittig zwischen den Stirnseiten des Grundkörpers angeordnete innen liegende Elektrodenschicht kann somit in vorteilhafter Weise von der Außenmetallisierung kontaktiert werden. Ferner können die Fasen zum einen kostengünstig hergestellt werden. Zum anderen kann hierdurch das abgetragene keramische Material reduziert werden. Ferner ist bei einer Ausgestaltung der Abtragungen in Form von Fasen das Risiko einer Beschädigung des Bauteils gering, wodurch sich eine hohe Gutausbringung ergibt.

Bei einer weiteren möglichen Ausgestaltung ist es vorteilhaft, dass der Grundkörper auf einer zylinderförmigen Ausgestaltung mit zumindest einer seitlichen Abflachung an der Außenseite basiert, dass die Außenmetallisierung auf der seitlichen Abflachung des Grundkörpers aufgebracht ist und dass die Fase, die an der Stirnseite des Grundkörpers vorgesehen ist, an der Stirnseite geradlinig entlang der seitlichen Abflachung des Grundkörpers verläuft und/oder dass die Fase, die an der weiteren Stirnseite des Grundkörpers vorgesehen ist, an der weiteren Stirnseite geradlinig entlang der seitlichen Abflachung des Grundkörpers verläuft. Hierbei ergibt sich der Vorteil, dass die Metallisierung der seitlichen Abflachung verfahrenstechnisch einfach realisiert werden kann. Speziell kann die seitliche Abflachung eben ausgestaltet sein, so dass die Metallisierung besonders einfach aufgebracht werden kann. Ferner kann bei dieser Ausgestaltung auch gezielt eine Begrenzung der Metallisierung auf die seitliche Abflachung erzielt werden.

Möglich ist es hierbei auch, dass eine weitere seitliche Abflachung an dem Grundkörper vorgesehen ist, dass eine weitere Außenmetallisierung auf der weiteren seitlichen Abflachung des Grundkörpers aufgebracht ist und dass eine Fase, die an der Stirnseite des Grundkörpers vorgesehen ist, an der Stirnseite geradlinig entlang der weiteren seitlichen Abflachung des Grundkörpers verläuft und/oder dass eine Fase, die an der weiteren Stirnseite des Grundkörpers vorgesehen ist, an der weiteren Stirnseite geradlinig entlang der weiteren seitlichen Abflachung des Grundkörpers verläuft. Insbesondere können die seitliche Abflachung und die weitere seitliche Abflachung voneinander abgewandt sein. Durch die Metallisierung an der seitlichen Abflachung und die weitere Metallisierung an der weiteren seitlichen Abflachung können somit zwei Außenelektroden gebildet werden. Diese beiden Außenelektroden können beide mit der gleichen innen liegenden Elektrodenschicht elektrisch kontaktiert sein. Bei einer abgewandelten Ausgestaltung ist es allerdings auch möglich, dass eine abwechselnde elektrische Kontaktierung von zwei oder mehr innen liegenden Elektrodenschichten über die beiden Metallisierungen an den beiden seitlichen Abflachungen realisiert ist. Hierdurch kann das piezoelektrische Bauteil auch aus mehr als zwei keramischen Schichten und mehr als zwei innen liegenden Elektrodenschichten aufgebaut werden.

Bei der Herstellung des piezoelektrischen Bauteils ist es vorteilhaft, dass der stangenförmige Block auf der gesamten Außenseite einheitlich mit einer Außenmetallisierung versehen wird. Speziell kann der stangenförmige Block mit einer zylindermantelförmigen Außenseite ausgebildet werden. Ferner ist es vorteilhaft, dass die Abtragung durch eine Fase, die die Stirnseite des Grundkörpers ringförmig umschließt, an der Stirnseite des Grundkörpers ausgestaltet wird und dass die innerhalb der Fase verbleibende Stirnseite des Grundkörpers mit der Metallisierung für die stirnseitige Außenelektrode beschichtet wird. Die Metallisierung für die stirnseitige Außenelektrode kann hierbei nach dem Ausgestalten der Fase aufgebracht werden. Allerdings kann die Metallisierung auch vor dem Ausgestalten der Fase aufgebracht werden. Dann kann gegebenenfalls auch ein Teil der stirnseitigen Metallisierung beim Einbringen der Fase in den Grundkörper wieder entfernt werden. Dies vereinfacht die Herstellung des piezoelektrischen Bauteils.

Vorteilhaft ist es allerdings auch, dass an dem stangenförmigen Block eine seitliche Abflachung ausgestaltet wird, die sich entlang einer Längsachse des stangenförmigen Blocks erstreckt und dass die Außenmetallisierung auf die seitliche Abflachung des Blocks aufgebracht wird. Hierbei kann die Außenseite des stangenförmigen Blocks insbesondere nur an der seitlichen Abflachung beschichtet werden. Ferner ist es hierbei vorteilhaft, dass die Abtragung durch eine Fase, die geradlinig entlang der seitlichen Abflachung des Grundkörpers, die sich aus der seitlichen Abflachung des Blocks ergibt, verläuft, an der Stirnseite des Grundkörpers ausgestaltet wird und dass die neben der Fase verbleibende Stirnseite des Grundkörpers mit der Metallisierung für die stirnseitige Außenelektrode beschichtet wird. Hierbei kann die Metallisierung nach der Ausgestaltung der Fase an dem Grundkörper aufgebracht werden. Allerdings kann die Metallisierung auch vor der Ausgestaltung der Fase an dem Grundkörper ausgestaltet werden.

### Kurze Beschreibung der Zeichnungen

Bevorzugte Ausführungsbeispiele der Erfindung sind in der nachfolgenden Beschreibung unter Bezugnahme auf die beigefügten Zeichnungen, in denen sich entsprechende Elemente mit übereinstimmenden Bezugszeichen versehen sind, näher erläutert. Es zeigen:
Fig. 1 ein piezoelektrisches Bauteil entsprechend einem ersten Ausführungsbeispiel der Erfindung in einer schematischen Darstellung;
Fig. 2 das in Fig. 1 dargestellte piezoelektrische Bauteil gemäß dem ersten Ausführungsbeispiel der Erfindung in einer schematischen Darstellung aus der in Fig. 1 mit II bezeichneten Blickrichtung;
Fig. 3 das in Fig. 1 dargestellte piezoelektrische Bauteil gemäß dem ersten Ausführungsbeispiel in einer schematischen Schnittdarstellung entlang der in Fig. 1 mit III bezeichneten Schnittlinie;
Fig. 4 ein piezoelektrisches Bauteil entsprechend einem zweiten Ausführungsbeispiel der Erfindung in einer schematischen Darstellung;
Fig. 5 das in Fig. 4 dargestellte piezoelektrische Bauteil gemäß dem zweiten Ausführungsbeispiel der Erfindung in einer schematischen Darstellung aus der in Fig. 4 mit V bezeichneten Blickrichtung;
Fig. 6 ein piezoelektrisches Bauteil entsprechend einem dritten Ausführungsbeispiel der Erfindung in einer schematischen Darstellung;
Fig. 7 das in Fig. 6 dargestellte piezoelektrische Bauteil gemäß dem dritten Ausführungsbeispiel der Erfindung in einer schematischen Schnittdarstellung entlang der in Fig. 6 mit VII bezeichneten Schnittlinie;
Fig. 8 ein Prozessflussdiagramm zur Erläuterung eines Verfahrens zur Herstellung des piezoelektrischen Bauteils gemäß dem ersten Ausführungsbeispiel entsprechend einer möglichen Ausgestaltung und
Fig. 9 ein Prozessflussdiagramm zur Erläuterung eines Verfahrens zur Herstellung des piezoelektrischen Bauteils gemäß dem zweiten Ausführungsbeispiel entsprechend einer möglichen Ausgestaltung der Erfindung.

### Ausführungsformen der Erfindung

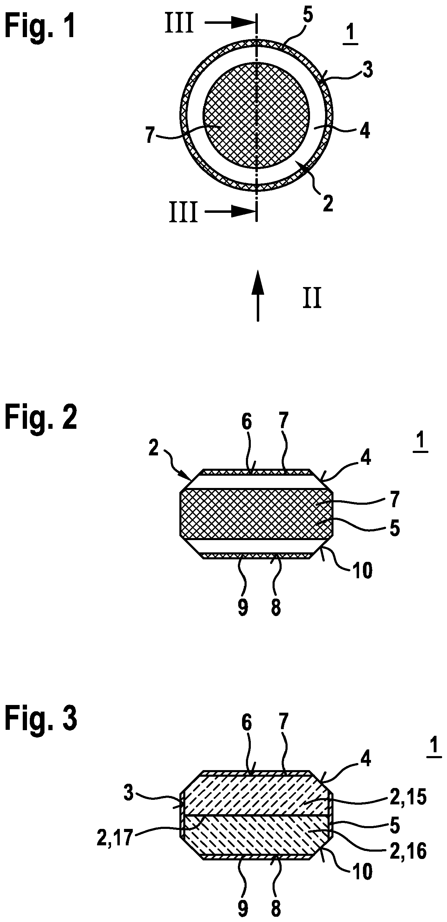

Fig. 1 zeigt ein piezoelektrisches Bauteil 1 in einer schematischen Darstellung entsprechend einem ersten Ausführungsbeispiel. Das piezoelektrische Bauteil 1 kann insbesondere als piezoelektrischer Sensor 1 dienen. Solch ein piezoelektrischer Sensor 1 kann insbesondere bei Brennstoffeinspritzanlagen zum Einsatz kommen. Beispielsweise kann der piezoelektrische Sensor 1 als Nadelschließsensor dienen, der ein Schließen einer Ventilnadel eines Brennstoffeinspritzventils überwacht. Hierbei kann der Sensor 1 auch einen Druckverlauf innerhalb eines Brennstoffraums des Brennstoffeinspritzventils messen. Der Sensor 1 kann auch als Brennraumdrucksensor 1 ausgestaltet sein, der direkt oder indirekt den Druck in einem Brennraum einer Brennkraftmaschine misst. Der piezoelektrische Sensor 1 eignet sich allerdings auch für andere Anwendungsfälle, insbesondere im Kraftfahrzeugbereich. Speziell kann der Sensor 1 auch als Betriebsmittelsensor für Hydraulik- oder Pneumatikanwendungen zum Einsatz kommen. Bei einer weiteren möglichen Ausgestaltung dient das piezoelektrische Bauteil 1 als piezoelektrischer Aktor 1.

Das piezoelektrische Bauteil 1 weist einen Grundkörper 2 auf. Der Grundkörper 2 weist eine Außenseite 3 auf, die in diesem Ausführungsbeispiel als zylindermantelförmige Außenseite 3 ausgestaltet ist. Ferner ist an dem Grundkörper 2 eine Abtragung 4 vorgesehen, die durch eine Fase 4 gebildet ist.

An der Außenseite 3 des Grundkörpers 2 ist eine Außenmetallisierung 5 vorgesehen, die sich in diesem Ausführungsbeispiel über die gesamte Außenseite 3 des Grundkörpers 2 erstreckt.

Ferner ist an einer Stirnseite 6 (Fig. 2) des Grundkörpers 2 eine stirnseitige Außenelektrode 7 vorgesehen. Die Fase 4 trennt die Außenmetallisierung 5 von der stirnseitigen Außenelektrode 7.

Fig. 2 zeigt das in Fig. 1 dargestellte piezoelektrische Bauteil 1 entsprechend dem ersten Ausführungsbeispiel in einer schematischen Darstellung aus der in Fig. 1 mit II bezeichneten Blickrichtung. Der Grundkörper 2 weist eine weitere Stirnseite 8 auf, an der eine weitere stirnseitige Außenelektrode 9 angebracht ist.

Die Fase 4 ist ringförmig ausgestaltet und umschließt die Stirnseite 6. Ferner ist eine weitere Abtragung 10 vorgesehen, die durch eine Fase 10 gebildet ist. Die Fase 10 ist im Bereich der weiteren Stirnseite 8 vorgesehen und umschließt die weitere Stirnseite 8 ringförmig. Durch die Fase 10 ist die weitere stirnseitige Außenelektrode 9 von der Außenmetallisierung 5 getrennt.

Fig. 3 zeigt das in Fig. 1 dargestellte piezoelektrische Bauteil 1 entsprechend dem ersten Ausführungsbeispiel in einer schematischen Schnittdarstellung entlang der in Fig. 1 mit III bezeichneten Schnittlinie. Der Grundkörper 2 weist eine erste keramische Schicht 15, eine zweite keramische Schicht 16 und eine innen liegende Elektrodenschicht 17 auf. Die innen liegende Elektrodenschicht 17 ist hierbei zwischen der ersten keramischen Schicht 15 und der zweiten keramischen Schicht 16 angeordnet. Die Außenmetallisierung 5, die sich über die zylindermantelförmige Außenseite 3 des Grundkörpers 2 erstreckt, kontaktiert die innen liegende Elektrodenschicht 17. Somit können in einfacher Weise elektrische Anschlüsse an der stirnseitigen Außenelektrode 7, der weiteren stirnseitigen Außenelektrode 9 und der mit der innen liegenden Elektrodenschicht 17 verbundenen Außenmetallisierung 5 angebracht werden.

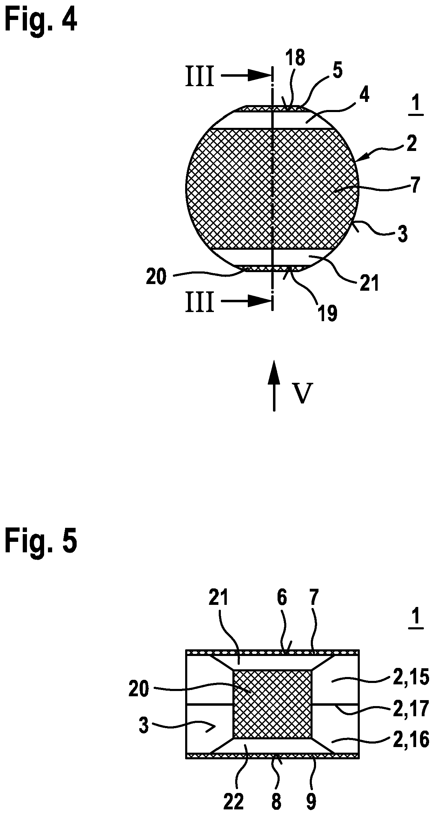

Fig. 4 zeigt ein piezoelektrisches Bauteil 1 gemäß einem zweiten Ausführungsbeispiel in einer schematischen Darstellung. In diesem Ausführungsbeispiel sind an dem Grundkörper 2 seitliche Abflachungen 18, 19 ausgestaltet. Die Außenseite 3 des Grundkörpers 2 ist nur an den seitlichen Abflachungen 18, 19 mit Außenmetallisierungen 5, 20 beschichtet. Da die seitlichen Abflachungen 18, 19 eben ausgestaltet sind, können die Außenmetallisierungen 5, 20 einfach aufgebracht werden.

Außerdem sind in diesem Ausführungsbeispiel im Bereich der Stirnseite 6 beziehungsweise der stirnseitigen Außenelektrode 7 Abtragungen 4, 21 vorgesehen, die durch Fasen 4, 21 gebildet sind. Hierbei erstreckt sich die Fase 4 an der Stirnseite 6 entlang der seitlichen Abflachung 18. Die Fase 21 erstreckt sich an der Stirnseite 6 entlang der seitlichen Abflachung 19.

Fig. 5 zeigt das in Fig. 4 dargestellte piezoelektrische Bauteil 1 gemäß dem zweiten Ausführungsbeispiel in einer schematischen Darstellung aus der in Fig. 4 mit V bezeichneten Blickrichtung. Die Fase 21 ist einerseits an der Stirnseite 6 beziehungsweise der stirnseitigen Außenelektrode 7 vorgesehen. Ferner ist an der weiteren Stirnseite 8 beziehungsweise der weiteren stirnseitigen Außenelektrode 9 eine weitere Abtragung 22 vorgesehen, die durch eine Fase 22 gebildet ist. Die Fasen 21, 22 erstrecken sich hierbei geradlinig entlang der seitlichen Abflachung 19, an der die Außenmetallisierung 20 vorgesehen ist.

Eine schematische Schnittdarstellung des in Fig. 1 dargestellten piezoelektrischen Bauteils 1 gemäß dem zweiten Ausführungsbeispiel entlang der in Fig. 4 mit III bezeichneten Schnittlinie entspricht in diesem Ausführungsbeispiel einer Darstellung, wie sie in der Fig. 3 gezeigt ist.

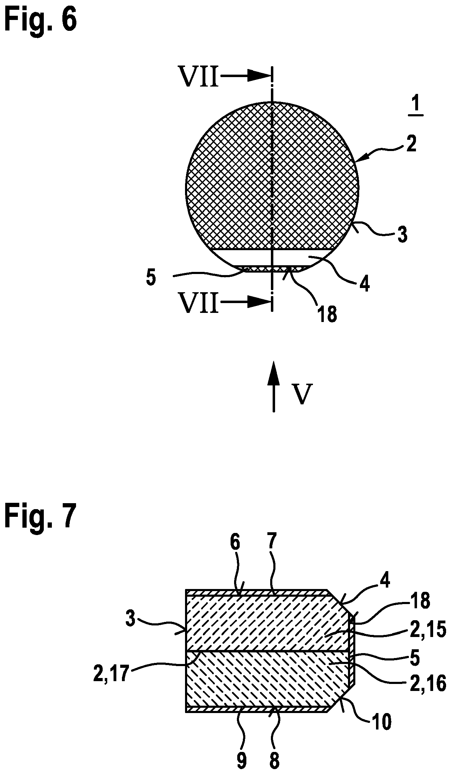

Fig. 6 zeigt ein piezoelektrisches Bauteil 1 entsprechend einem dritten Ausführungsbeispiel in einer schematischen Darstellung. In diesem Ausführungsbeispiel weist der Grundkörper 2 genau eine seitliche Abflachung 18 auf, an der die Außenmetallisierung 5 vorgesehen ist. Die Fase 4 erstreckt sich hierbei an der Stirnseite 6 geradlinig entlang der seitlichen Abflachung 18.

Fig. 7 zeigt das in Fig. 6 dargestellte piezoelektrische Bauteil 1 gemäß dem dritten Ausführungsbeispiel in einer schematischen Schnittdarstellung entlang der in Fig. 6 mit VII bezeichneten Schnittlinie. In diesem Ausführungsbeispiel weist das piezoelektrische Bauteil 1 genau eine Außenmetallisierung 5 auf. Diese Außenmetallisierung 5 ist einseitig auf der seitlichen Abflachung 18 an der Außenseite 3 des Grundkörpers 2 ausgestaltet. Im Unterschied dazu ist bei dem anhand der Fig. 4 und 5 beschriebenen zweiten Ausführungsbeispiel beidseitig jeweils eine Außenmetallisierung 5, 20 vorgesehen.

Eine Seitenansicht aus der in Fig. 6 mit V bezeichneten Blickrichtung auf das piezoelektrische Bauteil 1 entsprechend dem dritten Ausführungsbeispiel entspricht der in Fig. 5 gezeigten Darstellung, wenn die in der Fig. 6 mit V bezeichnete Blickrichtung gewählt ist.

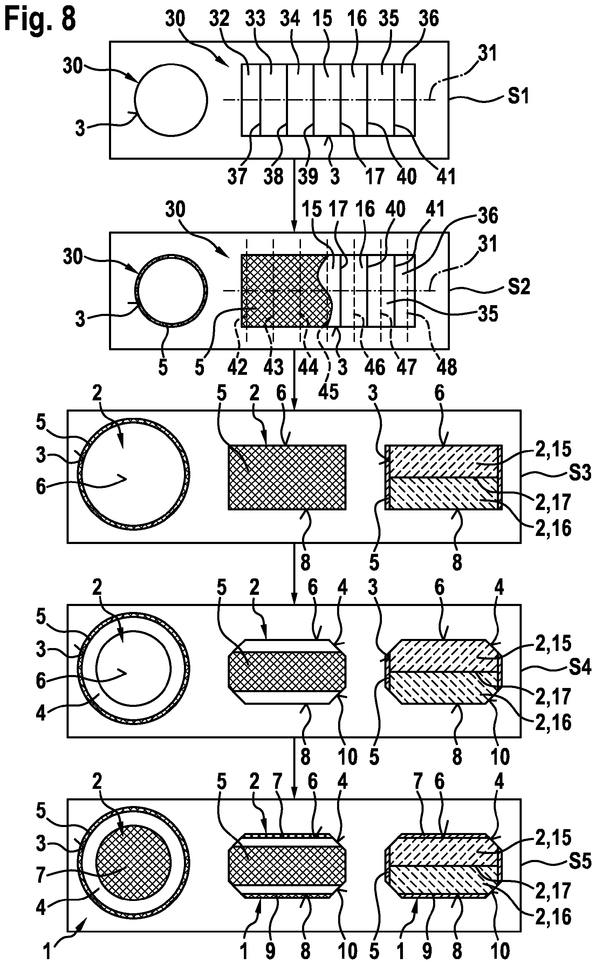

Fig. 8 zeigt ein Prozessflussdiagramm zur Erläuterung eines Verfahrens zur Herstellung des piezoelektrischen Bauteils 1 gemäß dem ersten Ausführungsbeispiel entsprechend einer möglichen Ausgestaltung. Hierbei sind Schritte S1 bis S5 dargestellt. In den Schritten S1, S2 ist auf der linken Seite jeweils ein Querschnitt eines stangenförmigen Blocks 30 dargestellt. Der Querschnitt ist hierbei senkrecht zu einer Längsachse 31 des stangenförmigen Blocks 30 gewählt. Auf der rechten Seite ist in den Schritten S1, S2 jeweils eine längsseitige Ansicht des stangenförmigen Blocks 30 dargestellt.

In den Schritten S3, S4, S5 ist auf der linken Seite jeweils eine Draufsicht auf den Grundkörper 2 dargestellt, wie es der in Fig. 1 gewählten Ansicht entspricht. In der Mitte ist jeweils eine Seitenansicht dargestellt, wie es der in Fig. 2 gewählten Ansicht entspricht. Rechts ist jeweils ein Schnitt durch den Grundkörper 2 dargestellt, wie es der in Fig. 3 gewählten Ansicht entspricht.

Im Schritt S1 wird als Ausgangsmaterial der stangenförmige Block 30 genutzt, der als Halbzeug vorbereitet sein kann. Der stangenförmige Block 30 weist eine Vielzahl von keramischen Schichten 15, 16, 32, 33, 34, 35, 36 und eine Vielzahl von zwischen den keramischen Schichten 15, 16, 32 bis 36 angeordneten innen liegenden Elektrodenschichten 17, 37, 38, 39, 40, 41 auf. Die Außenseite 3 des stangenförmigen Blocks 30 ist in diesem Ausführungsbeispiel zylindermantelförmig ausgestaltet. Der stangenförmige Block 30 ist hierbei zylinderförmig ausgestaltet.

Im Schritt S2, der auf den Schritt S1 folgt, wird die Außenseite 3 vollständig mit einer Außenmetallisierung 5 versehen. Die Außenmetallisierung 5 erstreckt sich somit entlang der Längsachse 31 über den gesamten stangenförmigen Block 30, wenn das Aufbringen der Außenmetallisierung 5 abgeschlossen ist. Anschließend wird der stangenförmige Block 30 an Trennlinien 42 bis 48 aufgetrennt. Bei den Trennlinien 42 bis 48 kann es sich insbesondere um Schnittlinien 42 bis 48 handeln. Insbesondere kann beispielsweise mit einer Diamantsäge eine Vereinzelung des stangenförmigen Blocks 30 in einzelne Scheiben mit jeweils zwei oder mehr keramischen Schichten 15, 16 erfolgen, die anschließend durch Schleifen stirnseitig nachbearbeitet werden können. Im Schritt S3 ist eine dieser Scheiben in Form des Grundkörpers 2 dargestellt. Hierbei sind ebene Stirnseiten 6, 8 gebildet, wobei die innen liegende Elektrodenschicht 17 möglichst mittig zwischen den Stirnseiten 6, 8 angeordnet ist. Dies ist durch eine geeignete Wahl der Schnittlinien 45, 46 erzielbar. Aufgrund der im Schritt S2 über die gesamte Außenseite 3 des stangenförmigen Blocks 30 aufgebrachte Außenmetallisierung 5 ist auch die Außenseite 3 des Grundkörpers 2 zunächst vollständig mit der Außenmetallisierung 5 versehen. Die Stirnseiten 6, 8 liegen noch frei.

Im Schritt S4, der auf den Schritt S3 folgt, werden die Fasen 4, 10 an dem Grundkörper 2 im Bereich der Stirnseiten 6, 8 ausgestaltet.

Im Schritt S5, der auf den Schritt S4 folgt, werden an den Stirnseiten 6, 8 stirnseitige Außenelektroden 7, 9 angebracht. Die Außenmetallisierung 5 ist nun einerseits durch die Fase 4 von der stirnseitigen Außenelektrode 7 und andererseits durch die Fase 10 von der stirnseitigen Außenelektrode 9 getrennt.

Nach dem Abschluss des Schrittes S5 ist das piezoelektrische Bauteil 1 hergestellt.

Der stangenförmige Block 30 wird vorzugsweise so hergestellt, dass die innen liegenden Elektrodenschichten 17, 37 bis 41 entlang der Längsachse 31 äquidistant voneinander beabstandet sind. Entsprechend werden dann die Trennlinien 42 bis 48 äquidistant zueinander gelegt. Vorzugsweise befinden sich die Trennlinien 43 bis 47 dann jeweils in der Mitte zwischen benachbarten innen liegenden Elektrodenschichten 17, 37 bis 41. Die äußersten Trennlinien 42, 48 sind in ihrer Lage dann aufgrund der vorgegebenen Äquidistanz bestimmt. Hierdurch werden gleich große Grundkörper 2 abgetrennt, bei denen die innen liegenden Elektrodenschichten 17, 37 bis 41 jeweils zwischen den entsprechenden Stirnseiten 6, 8 liegen.

Bei einer abgewandelten Ausgestaltung kann die anhand des Schrittes S5 beschriebene Metallisierung der Stirnseiten 6, 8 vor dem Schritt S4 durchgeführt werden, in dem die Fasen 4, 10 an dem Grundkörper 2 ausgestaltet werden.

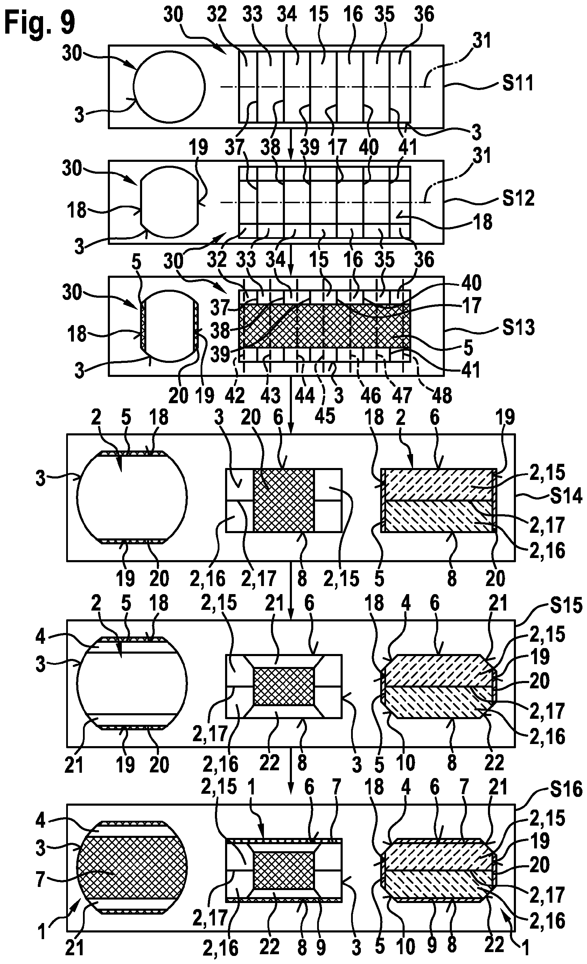

Fig. 9 zeigt ein Prozessflussdiagramm zur Erläuterung eines Verfahrens zur Herstellung des piezoelektrischen Bauteils gemäß dem zweiten Ausführungsbeispiel entsprechend einer möglichen Ausgestaltung. Hierbei sind Verfahrensschritte S11 bis S16 gezeigt. Die in den Verfahrensschritten S11 bis S13 gewählte Darstellung entspricht der Darstellung, die in der Fig. 8 bei den Verfahrensschritten S1, S2 gewählt ist. Die in den Verfahrensschritten S14 bis S16 gewählte Darstellung entspricht der Darstellung, die in der Fig. 8 bei den Verfahrensschritten S3 bis S5 gewählt ist.

Im Schritt S11 wird der stangenförmige Block 30 als Halbzeug hergestellt. Hierbei ist ein Schichten der Vielzahl von keramischen Schichten 15, 16, 32 bis 36 und Elektrodenschichten 17, 37 bis 41 zu dem Block 30 möglich. Der stangenförmige Block 30 wird hierbei vorzugsweise als keramische Mehrschichtstruktur hergestellt. Dies kann durch Stapeln und Laminieren von geeigneten Grünfolien realisiert werden, wobei nach einer gewissen Anzahl von Grünfolien jeweils eine Innenelektrodenpaste für die jeweilige innen liegende Elektrodenschicht 17, 37 bis 41 durch Bedrucken aufgebracht wird. Die so hergestellten stangenförmigen Blöcke 30 können dann entbindert und gesintert werden. Somit kann sich die Herstellung teilweise an eine konventionelle Verfahrensweise anlehnen, bei der piezokeramisches Material in Form von stabförmigen Halbzeugen zum Einsatz kommt. Jedoch weist der im Schritt S11 hergestellte stangenförmige Block 30 bereits die innen liegenden Elektrodenschichten 17, 37 bis 41 in definierten Abständen auf. Im Schritt S12, der auf den Schritt S11 folgt, werden an dem stangenförmigen Block 30 seitliche Abflachungen 18, 19 ausgestaltet. Dies kann beispielsweise durch Beschleifen des stangenförmigen Blocks 30 erfolgen. Hierbei werden die seitlichen Abflachungen 18, 19 entlang der Längsachse 31 an dem gesamten stangenförmigen Block 30 ausgestaltet.

Im Schritt S13, der auf den Schritt S12 folgt, wird zunächst auf den seitlichen Abflachungen 18, 19 jeweils die zugeordnete Außenmetallisierung 5, 20 angebracht. Der übrige Teil der Außenseite 3 bleibt hierbei frei.

Anschließend wird im Schritt S13 eine Vereinzelung des stangenförmigen Blocks 30 durch eine Diamantsäge oder dergleichen ausgeführt. Hierbei erfolgt die Vereinzelung entlang von Trennlinien 42 bis 48. Im Unterschied zu dem anhand der Fig. 8 beschriebenen Ausgestaltung ergibt sich hierbei der Vorteil, dass die innen liegenden Elektrodenschichten 17, 37 bis 41 gegebenenfalls auf dem frei liegenden Teil der nicht metallisierten Außenseite 3 sichtbar sind und somit zur Ausrichtung des Trennwerkzeugs, insbesondere der Diamantsäge, genutzt werden können. Nach der Vereinzelung ergibt sich unter anderem ein Grundkörper 2 mit den Außenmetallisierungen 5, 20, der in den Schritten S14 bis S16 exemplarisch weiter betrachtet wird.

Im Schritt S14 wird der einzelne Grundkörper 2 mit den Außenmetallisierungen 5, 20 aus den mehreren vereinzelten Scheiben des stangenförmigen Blocks 30 gewählt.

Im Schritt S15, der auf den Schritt S14 folgt, werden die an den Stirnseiten 6, 8 vorgesehenen Kanten zwischen den metallisierten seitlichen Abflachungen 18, 19 und den Stirnseiten 6, 8 mit insgesamt vier Fasen 4, 10, 21, 22 versehen. Durch die Fasen 4, 10, 21, 22 sind Abstände zwischen den Außenmetallisierungen 5, 20 und den Stirnseiten 6, 8 gebildet.

Im Schritt S16, der auf den Schritt S15 folgt, werden die Stirnseiten 6, 8 mit stirnseitigen Außenelektroden 7, 9 versehen. Durch die Fasen 4, 10, 21, 22 ist eine elektrische Isolierung zwischen der Außenmetallisierung 5, der weiteren Außenmetallisierung 20, der stirnseitigen Außenelektrode 7 und der stirnseitigen Außenelektrode 9 gewährleistet. Somit können beispielsweise die stirnseitigen Außenelektroden 7, 9 auf Masse gelegt werden, während die Außenmetallisierungen 5, 20 zum Abgreifen eines elektrischen Signals beziehungsweise zum Anlegen einer elektrischen Spannung gegenüber Masse dienen.

Bei einer abgewandelten Ausgestaltung kann der Schritt S16, in dem die stirnseitigen Außenelektroden 7, 9 aufgebracht werden, auch bereits vor dem Schritt S15 ausgeführt werden.

Einsatzmöglichkeiten des piezoelektrischen Bauteils 1 in möglicherweise entsprechend abgewandelten Ausgestaltungen sind Mehrlagen-Sensoren, Mehrlagen-Aktoren oder andere funktionskeramische Bauteile 1. Insbesondere ist ein Einsatz auch bei Druck- und Ultraschallanwendungen möglich.

Die Erfindung ist nicht auf die beschriebenen Ausführungsbeispiele beschränkt, sondern durch die Ansprüche definiert.

## Patentansprüche

1. Piezoelektrisches Bauteil (1), insbesondere piezoelektrischer Sensor oder piezoelektrischer Aktor, mit einem Grundkörper (2), der eine erste keramische Schicht (15), eine zweite keramische Schicht (16) und eine innen liegende Elektrodenschicht (17) aufweist, wobei eine Außenmetallisierung (5) vorgesehen ist, die auf eine Außenseite (3) des Grundkörpers (2) aufgebracht ist und die innen liegende Elektrodenschicht (17) kontaktiert, wobei der Grundkörper (2) eine Abtragung (4) aufweist und wobei die Abtragung (4) die Außenmetallisierung (5) von einer stirnseitigen Außenelektrode (7) trennt, die durch eine Metallisierung (7) einer Stirnseite (6) des Grundkörpers (2) ausgebildet ist, und wobei auf einer weiteren Stirnseite (8) des Grundkörpers (2), die von der Stirnseite (6) abgewandt ist, eine Metallisierung (9) aufgebracht ist, die eine weitere stirnseitige Außenelektrode (9) bildet, und dass der Grundkörper (2) eine weitere Abtragung (10) aufweist, die die Außenmetallisierung (5) von der weiteren stirnseitigen Außenelektrode (9) trennt, wobei die Abtragung (4) als Fase (4) ausgestaltet ist, die an der Stirnseite (6) des Grundkörpers (2) angebracht ist, und die weitere Abtragung (10) als Fase (10) ausgestaltet ist, die an der weiteren Stirnseite (8) des Grundkörpers (2) angebracht ist, **dadurch gekennzeichnet, dass** der Grundkörper (2) auf einer zylinderförmigen Ausgestaltung basiert und die Außenmetallisierung (5) einheitlich auf eine zylindermantelförmige Außenseite (3) des Grundkörpers (2) aufgebracht ist und die Fase (4), die an der Stirnseite (6) des Grundkörpers (2) angebracht ist, die Stirnseite (6) des Grundkörpers (2) ringförmig umschließt und die Fase (10), die an der weiteren Stirnseite (8) des Grundkörpers (2) angebracht ist, die weitere Stirnseite (8) des Grundkörpers (2) ringförmig umschließt.

2. Piezoelektrisches Bauteil nach Anspruch 1,
**dadurch gekennzeichnet,**
**dass** der Grundkörper (2) auf einer zylinderförmigen Ausgestaltung mit zumindest einer seitlichen Abflachung (18, 19) an der Außenseite (3) basiert, dass die Außenmetallisierung (5, 20) auf der seitlichen Abflachung (18, 19) des Grundkörpers (2) aufgebracht ist und dass die Fase (4, 21), die an der Stirnseite (6) des Grundkörpers (2) angebracht ist, an der Stirnseite (6) geradlinig entlang der seitlichen Abflachung (18, 19) des Grundkörpers (2) verläuft und/oder dass die Fase (10, 22), die an der weiteren Stirnseite (8) des Grundkörpers (2) angebracht ist, an der weiteren Stirnseite (8) geradlinig entlang der seitlichen Abflachung (18, 19) des Grundkörpers (2) verläuft.

3. Verfahren zur Herstellung eines piezoelektrischen Bauteils (1), insbesondere eines piezoelektrischen Sensors oder eines piezoelektrischen Aktors, wobei auf eine Außenseite (3) eines stangenförmigen Blocks (30), der eine Vielzahl von keramischen Schichten (15, 16, 32 - 36) und eine Vielzahl von zwischen den keramischen Schichten (15, 16, 32 - 36) angeordneten Elektrodenschichten (17, 37 - 41) aufweist, eine Außenmetallisierung (5) aufgebracht wird, wobei von dem stangenförmigen Block (30) ein Grundkörper (2) abgetrennt wird, wobei von dem Grundkörper (2) eine Abtragung (4) abgetragen wird, wobei an einer Stirnseite (6) des Grundkörpers (2) eine Metallisierung (7) ausgebildet wird, die eine stirnseitige Außenelektrode (7) bildet, und wobei die Abtragung (4) so ausgestaltet wird, dass die Außenmetallisierung (5) durch die Abtragung (4) von der stirnseitigen Außenelektrode (7) getrennt ist, wobei die Außenmetallisierung (5) einheitlich auf die gesamte Außenseite (3) des stangenförmigen Blocks (30) aufgebracht wird **dadurch gekennzeichnet, dass** der stangenförmige Block (30) mit einer zylindermantelförmigen Außenseite (3) ausgebildet wird, und die Abtragung (4) durch eine Fase (4), die die Stirnseite (6) des Grundkörpers (2) ringförmig umschließt, an der Stirnseite (6) des Grundkörpers (2) ausgestaltet wird und die innerhalb der Fase (4) verbleibende Stirnseite (6) des Grundkörpers (2) mit der Metallisierung (7) für die stirnseitige Außenelektrode (7) beschichtet wird.

4. Verfahren nach Anspruch 3,
**dadurch gekennzeichnet,**
**dass** an dem stangenförmigen Block (30) eine seitliche Abflachung (18, 19) ausgestaltet wird, die sich entlang einer Längsachse (31) des stangenförmigen Blocks (30) erstreckt, und dass die Außenmetallisierung (5, 20) auf die seitliche Abflachung (18, 19) des stangenförmigen Blocks (30) aufgebracht wird.

5. Verfahren nach Anspruch 4,
**dadurch gekennzeichnet,**
**dass** die Abtragung (4, 21) durch eine Fase (4, 21), die geradlinig entlang der seitlichen Abflachung (18, 19) des Grundkörpers (2), die sich aus der seitlichen Abflachung (18, 19) des stangenförmigen Blocks (30) ergibt, verläuft, an der Stirnseite (6) des Grundkörpers (2) ausgestaltet wird und dass die neben der Fase (4, 11) verbleibende Stirnseite (6) des Grundkörpers (2) mit der Metallisierung (7) für die stirnseitige Außenelektrode (7) beschichtet wird.

## Claims

1. Piezoelectric component (1), in particular a piezoelectric sensor or a piezoelectric actuator, with a main body (2), which has a first ceramic layer (15), a second ceramic layer (16) and an inner electrode layer (17), an outer metallization (5) being provided, applied to an outer side (3) of the main body (2) and contacting the inner electrode layer (17), the main body (2) having a removal of material (4) and the removal of material (4) separating the outer metallization (5) from an end-face outer electrode (7), which is formed by a metallization (7) of an end face (6) of the main body (2), and wherein on a further end face (8) of the main body (2) that is remote from the end face (6) there is applied a metallization (9), which forms a further end-face outer electrode (9), and in that the main body (2) has a further removal of material (10), which separates the outer metallization (5) from the further end-face outer electrode (9), wherein the removal of material (4) is configured as a bevel (4) that is attached on the end face (6) of the main body (2) and the further removal of material (10) is configured as a bevel (10) that is attached on the further end face (8) of the main body (2), **characterized in that** the main body (2) is based on a cylindrical configuration and the outer metallization (5) is applied as one to an outer side (3) of the main body (2) in the form of a cylindrical shell and **in that** the bevel (4) that is attached on the end face (6) of the main body (2) encloses the end face (6) of the main body (2) in an annular manner and the bevel (10) that is attached on the further end face (8) of the main body (2) encloses the further end face (8) of the main body (2) in an annular manner.

2. Piezoelectric component according to Claim 1,
**characterized**
**in that** the main body (2) is based on a cylindrical configuration with at least one lateral flattening (18, 19) on the outer side (3), in that the outer metallization (5, 20) is applied on the lateral flattening (18, 19) of the main body (2) and in that the bevel (4, 21) that is attached on the end face (6) of the main body (2) runs on the end face (6) in a straight line along the lateral flattening (18, 19) of the main body (2) and/or in that the bevel (10, 22) that is attached on the further end face (8) of the main body (2) runs on the further end face (8) in a straight line along the lateral flattening (18, 19) of the main body (2).

3. Method for producing a piezoelectric component (1), in particular a piezoelectric sensor or a piezoelectric actuator, an outer metallization (5) being applied to an outer side (3) of a block (30) in rod form, which has a multiplicity of ceramic layers (15, 16, 32 - 36) and a multiplicity of electrode layers (17, 37 - 41) arranged between the ceramic layers (15, 16, 32 - 36), a main body (2) being cut off from the block (30) in rod form, a removal of material (4) being removed from the main body (2), a metallization (7), which forms an end-face outer electrode (7), being formed on an end face (6) of the main body (2), and the removal of material (4) being configured such that the outer metallization (5) is separated from the end-face outer electrode (7) by the removal of material (4), wherein the outer metallization (5) is applied as one to the entire outer side (3) of the block (30) in rod form, **characterized in that** the block (30) in rod form is formed with an outer side (3) in the form of a cylindrical shell, and the removal of material (4) is configured in the form of a bevel (4), which encloses the end face (6) of the main body (2) in an annular form, on the end face (6) of the main body (2) and **in that** the end face (6) of the main body (2) remaining within the bevel (4) is coated with the metallization (7) for the end-face outer electrode (7).

4. Method according to Claim 3,
**characterized**
**in that** a lateral flattening (18, 19) that extends along a longitudinal axis (31) of the block (30) in rod form is configured on the block (30) in rod form and in that the outer metallization (5, 20) is applied to the lateral flattening (18, 19) of the block (30) in rod form.

5. Method according to Claim 4,
**characterized in that** the removal of material (4, 21) is configured in the form of a bevel (4, 21), which runs in a straight line along the lateral flattening (18, 19) of the main body (2) that is obtained from the lateral flattening (18, 19) of the block (30) in rod form, on the end face (6) of the main body (2), and **in that** the end face (6) of the main body (2) remaining alongside the bevel (4, 11) is coated with the metallization (7) for the end-face outer electrode (7).

## Revendications

1. Composant piézoélectrique (1), notamment capteur piézoélectrique ou actionneur piézoélectrique, comprenant un corps de base (2), lequel possède une première couche en céramique (15), une deuxième couche en céramique (16) et une couche d'électrode interne (17), une métallisation externe (5) étant présente, laquelle est appliquée sur un côté extérieur (3) du corps de base (2) et vient en contact avec la couche d'électrode interne (17), le corps de base (2) présentant une partie enlevée (4) et la partie enlevée (4) séparant la métallisation externe (5) d'une électrode externe (7) côté frontal, laquelle est formée par une métallisation (7) d'un côté frontal (6) du corps de base (2), et une métallisation (9) étant appliquée sur un côté frontal (8) supplémentaire du corps de base (2), qui se trouve à l'opposé du côté frontal (6), laquelle forme une électrode externe (9) côté frontal supplémentaire, et que le corps de base (2) présente une partie enlevée (10) supplémentaire qui sépare la métallisation externe (5) de l'électrode externe (9) côté frontal supplémentaire, la partie enlevée (4) étant réalisée sous la forme d'un biseau (4) qui est appliqué au niveau du côté frontal (6) du corps de base (2), et la partie enlevée (10) supplémentaire étant réalisée sous la forme d'un biseau (10) qui est appliqué au niveau du côté frontal (8) supplémentaire du corps de base (2),
caractérisé en que le corps de base (2) s'appuie sur une configuration de forme cylindrique et la métallisation externe (5) est appliquée uniformément sur un côté extérieur (3) en forme d'enveloppe cylindrique du corps de base (2) et le biseau (4) qui est appliqué au niveau du côté frontal (6) du corps de base (2) entoure en forme d'anneau le côté frontal (6) du corps de base (2) et le biseau (10) qui est appliqué au niveau du côté frontal (8) supplémentaire du corps de base (2) entoure en forme d'anneau le côté frontal (8) supplémentaire du corps de base (2).

2. Composant piézoélectrique selon la revendication 1, **caractérisé en ce que** le corps de base (2) s'appuie sur une configuration de forme cylindrique comprenant au moins un méplat latéral (18, 19) au niveau du côté extérieur (3), **en ce que** la métallisation externe (5, 20) est appliquée sur le méplat latéral (18, 19) du corps de base (2) et **en ce que** le biseau (4, 21) qui est appliqué au niveau du côté frontal (6) du corps de base (2) s'étend au niveau du côté frontal (6) en ligne droite le long du méplat latéral (18, 19) du corps de base (2) et/ou **en ce que** le biseau (10, 22) qui est appliqué au niveau du côté frontal (8) supplémentaire du corps de base (2) s'étend au niveau du côté frontal (8) supplémentaire en ligne droite le long du méplat latéral (18, 19) du corps de base (2).

3. Procédé de fabrication d'un composant piézoélectrique (1), notamment d'un capteur piézoélectrique ou d'un actionneur piézoélectrique, une métallisation externe (5) étant appliquée sur un côté extérieur (3) d'un bloc en forme de tige (30), lequel possède une pluralité de couches en céramique (15, 16, 32-36) et une pluralité de couches d'électrode (17, 37-41) disposées entre les couches en céramique (15, 16, 32-36), un corps de base (2) étant sectionné du bloc en forme de tige (30), une partie enlevée (4) étant enlevée du corps de base (2), une métallisation (7) étant formée au niveau d'un côté frontal (6) du corps de base (2), laquelle forme une électrode externe (7) côté frontal, et la partie enlevée (4) étant configurée de telle sorte que la métallisation externe (5) est séparée de l'électrode externe (7) côté frontal par la partie enlevée (4), la métallisation externe (5) étant appliquée uniformément sur la totalité du côté extérieur (3) du bloc en forme de tige (30),
caractérisé en que le bloc en forme de tige (30) est réalisé avec un côté extérieur (3) en forme d'enveloppe cylindrique, et la partie enlevée (4) est configurée au niveau du côté frontal (6) du corps de base (2) par un biseau (4) qui entoure en forme d'anneau le côté frontal (6) du corps de base (2) et le côté frontal (6) du corps de base (2) restant à l'intérieur du biseau (4) est enduit avec la métallisation (7) pour l'électrode externe (7) côté frontal.

4. Procédé selon la revendication 3, **caractérisé en ce qu'**un méplat latéral (18, 19) est configuré sur le bloc en forme de tige (30), lequel s'étend le long d'un axe longitudinal (31) du bloc en forme de tige (30), et **en ce que** la métallisation externe (5, 20) est appliquée sur le méplat latéral (18, 19) du bloc en forme de tige (30) .

5. Procédé selon la revendication 4, **caractérisé en ce que** la partie enlevée (4, 21) est configurée sur le côté frontal (6) du corps de base (2) par un biseau (4, 21) qui s'étend en ligne droite le long du méplat latéral (18, 19) du corps de base (2), lequel résulte du méplat latéral (18, 19) du bloc en forme de tige (30), et **en ce que** le côté frontal (6) du corps de base (2) restant à côté du biseau (4, 11) est enduit avec la métallisation (7) pour l'électrode externe (7) côté frontal.
